# EUROPÄISCHE PATENTSCHRIFT

(11) **EP 2 422 364 B1**
(45) Veröffentlichungstag und Bekanntmachung des Hinweises auf die Patenterteilung: **23.03.2016**
(21) Anmeldenummer: 10712900.9
(22) Anmeldetag: 31.03.2010
(51) Int. Cl.: H01L 21/67, H01L 21/68, H01L 21/687

(54) **VORRICHTUNG ZUR AUSRICHTUNG UND VORFIXIERUNG EINES WAFERS**
DEVICE FOR ALIGNING AND PRE-ATTACHING A WAFER
DISPOSITIF D'ORIENTATION ET DE PRÉFIXATION D'UNE TRANCHE

(30) Priorität: 25.04.2009 DE 102009018977
(43) Veröffentlichungstag der Anmeldung: 29.02.2012
(73) Patentinhaber: EV Group GmbH, 4782 St. Florian am Inn (AT)
(72) Erfinder: BURGGRAF, Jürgen, A-4780 Schärding/Inn (AT); LINDNER, Paul, A-4780 Schärding (AT); PARGFRIEDER, Stefan, A-4204 Reichenau (AT); BURGSTALLER, Daniel, A- 4910 Neuhofen/Innkreis (AT)
(74) Vertreter: Schweiger, Johannes
(86) Internationale Anmeldenummer: PCT/EP2010/002053
(87) Internationale Veröffentlichungsnummer: WO 2010/121702

(56) Entgegenhaltungen:
- EP-A1- 1 458 013
- EP-A2- 1 450 398
- JP-A- 4 149 917
- JP-A- 2002 313 688
- JP-A- 2004 207 436
- US-A1- 2005 160 992

## Beschreibung

Die Erfindung betrifft eine Vorrichtung zur Ausrichtung und Vorfixierung eines flächigen Substrats auf einem Trägersubstrat für die Weiterverarbeitung des Substrats gemäß Anspruch 1. Weiterhin betrifft die vorliegende Erfindung ein Verfahren gemäß Anspruch 11.

Um sehr dünne Substrate, insbesondere Halbleitersubstrate wie Wafer mit einer Dicke von wenigen nm bis zu 250 µm herstellen zu können, werden diese üblicherweise auf Trägersysteme montiert. Ausgehend von einem dicken (üblicherweise größer 250 µm) Substrat wird meist eine Trägerfolie einseitig laminiert (so genanntes "Back Thinning Tape"), um das Substrat anschließend rückdünnen zu können.

Das Rückdünnen von Wafern ist in der Halbleiterindustrie häufig erforderlich und kann mechanisch und/oder chemisch erfolgen. Zum Rückdünnen werden die Wafer in der Regel auf einen Träger vorübergehend fixiert, wobei es für die Fixierung verschiedene Methoden gibt. Als Trägermaterial werden beispielsweise Folien, Glassubstrate oder Siliziumwafer verwendet. Am Ende des Rückdünnvorganges und der Nachbearbeitung innerhalb einer Anlage werden die rückgedünnten Substrate auf Filmrahmen montiert und anschließend wird das Trägermaterial entfernt.

Sobald eine über das Rückdünnen hinausgehende Bearbeitung des Substrats nötig wird, kommen starre Trägersysteme zum Einsatz. Beispiele für solche Bearbeitungsschritte auf Prozessanlagen nach dem Rückdünnen sind: Metallisierung, Trockenätzen, Nassätzen, Laserbearbeitung, Lithographie, Dotierung etc..

Bei starren Trägersystemen wird das zu bearbeitende Substrat durch eine Klebeschicht mit einem Trägersubstrat verbunden. Das Trägersubstrat ist typischerweise zwischen 250 und 1.500 µm dick.

Das Trägersubstrat soll dem beliebig dünnen zu bearbeitenden Substrat ausreichend mechanische Stabilität verleihen, um in weiterführenden Prozessschritten beziehungsweise Prozessanlagen bearbeitet werden zu können. Die Wahl des Trägersubstrats sowie des Klebers hängt von den Anforderungen der nachfolgenden Bearbeitungsschritte ab. Insbesondere die maximale Einsatztemperatur, Vakuumbeständigkeit, optische Transparenz, chemische Beständigkeit sowie die Fähigkeit, Unebenheiten auszugleichen, sind zu berücksichtigen.

Der Zweck solcher Trägersysteme besteht darin, die dünnen Substrate auf mechanisch stabilen Trägersubstraten in Standardanlagen beziehungsweise Standardprozessen weiter bearbeiten zu können, ohne die dünnen Substrate bei der Weiterbearbeitung zu beschädigen oder auf die dünnen Substrate spezifisch eingerichtete, teure Anlagen zu entwickeln.

Auch beim Transport der dünnen Substrate von einer Anlage zur nächsten ist ein Schutz der teilweise bereits bearbeiteten Substrate wichtig, um Beschädigungen der zerbrechlichen Substrate zu vermeiden.

Einige der vorgenannten Bearbeitungsschritte erfordern eine exakte Positionierung des Substrats beziehungsweise des Trägers innerhalb der entsprechenden Anlage, beispielsweise unter einem Mikroskop mit hoher Vergrößerung. Dort muss das Substrat innerhalb von µm positioniert sein, um eine rasche Weiterbearbeitung/Inspektion zu ermöglichen. Ist die zu erfassende Position des Substrats nach der Positionierung nicht im Blickfeld des Mikroskops, ist eine Suchroutine beziehungsweise Nachjustierung erforderlich, wodurch die Produktivität sinkt. Die Positionierung erfolgt beispielsweise an der Außenkontur des Substrats oder Trägers, beispielsweise einem abgeflachten Bereich (so genannter "Flat") oder einer Ausnehmung (so genannte "Notch").

Es ist daher häufig erforderlich, dass bei Trägersystemen anhand der Trägeraußenkontur eine Positionierung des Substrats vorgenommen wird, so dass eine möglichst exakte Positionierung des Substrats auf dem Träger wünschenswert ist.

Da die Außenkonturen der Substrate beziehungsweise Trägersubstrate mit teils erheblichen Fertigungstoleranzen behaftet sind, ist eine Positionierung mit einfachen mechanischen Anschlägen nicht ausreichend für eine µm-genaue Positionierung. Sehr eng tolerierte Substratabmessungen wären mit einem erheblichen Mehraufwand bei der Herstellung nicht mehr wirtschaftlich. Auch ein Aufbringen von optisch erfassbaren Passmarken verteuert das Trägersystem und ist nicht in allen Fällen möglich.

Vorrichtungen zum Ausrichten und Vorfixieren von Wafern sind in der JP 2004 207436 A, KR 100 886 957 B1, US 2005/0173781 A1, JP 2002-313 688 A und der DE 10 2007 035 788 A1 gezeigt.

Es ist daher die Aufgabe der vorliegenden Erfindung, eine Vorrichtung und ein korrespondierendes Verfahren anzugeben, mit welchen eine genaue Positionierung eines auf einem Trägersubstrat fixierten flächigen Substrats ermöglicht wird und die gleichzeitig universell einsetzbar sind.

Diese Aufgabe wird mit den Merkmalen der Ansprüche 1 und 11 gelöst. Vorteilhafte Weiterbildungen der Erfindung sind in den Unteransprüchen angegeben.

Der Erfindung liegt der Gedanke zugrunde, eine gattungsgemäße Vorrichtung sowie ein gattungsgemäßes Verfahren derart zu verbessern, dass die Ausrichtung von Substrat und, insbesondere für die Weiterverarbeitung geeignetem, Trägersubstrat anhand der Außenkontur beziehungsweise des Umfangs des Substrats und des Trägersubstrats erfolgt. Weiterhin sind erfindungsgemäß Fixiermittel zur zumindest teilweisen Vorfixierung des ausgerichteten Substrats auf dem Trägersubstrat vorgesehen. Bevorzugt erfolgt die Ausrichtung ohne optische Hilfsmittel, insbesondere durch Verwendung mechanischer Ausrichtungsmittel. Besonders bevorzugt ist die Verwendung einer beweglichen Mechanik, vorzugsweise einer beweglichen Mechanik sowohl für die Ausrichtung des Substrats als auch für die Ausrichtung des Trägersubstrats. Dabei ist es von besonderem Vorteil, wenn die Ausrichtungsmittel in einer eigenen Anlage, insbesondere getrennt von einer Anlage zum Bonden des Substrats angeordnet sind. Die vorliegende Erfindung betrifft daher eine Vorrichtung und ein Verfahren, mit der zwei Substrate, nämlich ein Substrat und ein Trägersubstrat, mechanisch und unabhängig von mit Fertigungstoleranzen behafteten Abmessungen exakt zueinander justierbar beziehungsweise ausrichtbar sind.

Das Trägersubstrat dient als mechanischer Stabilisator. Das Trägersubstrat verleiht dem Verbund aus Substrat und Trägersubstrat ausreichend mechanische Steifigkeit, um eine Bearbeitung des dünnen Substrats möglichst zerstörungsfrei zu ermöglichen. Die Abmessungen des Substrats sind mit Vorteil gleich oder geringfügig kleiner wie das Trägersubstrat, beispielsweise bei einem Durchmesser des Trägersubstrats von 200,0 mm ein Durchmesser des Substrats von 199,6 mm.

Als Substrat kommen beispielsweise Wafer in Frage, die rund oder rechteckig sein können, mit oder ohne Flats oder Notches.

In einer vorteilhaften Ausführungsform in der Erfindung ist vorgesehen, dass die Ausrichtungsmittel, insbesondere ausschließlich, in Radialrichtung R des Substrats und/oder des Trägersubstrats wirkend ausgebildet sind.

Alternativ können die Ausrichtungsmittel, insbesondere ausschließlich, quer zur Substrataußenkontur und/oder zur Trägersubstrataußenkontur wirkend ausgebildet sein. Auf diese Weise ist eine flexible und universelle Ausrichtung des Substrats mit dem Trägersubstrat und/oder der Aufnahmeeinrichtung möglich.

Gemäß einer weiteren vorteilhaften Ausführungsform der Erfindung umfassen die Ausrichtungsmittel mindestens drei an der Substrataußenkontur verteilt anordenbare E-Aktuatoren zur Ausrichtung des Substrats sowie Positionserfassungsmittel zur Erfassung der Position der E-Aktuatoren. Die Verwendung von Aktuatoren bringt den Vorteil mit sich, dass eine hochgenaue Steuerung, insbesondere weg- und/oder kraftabhängig, bei der Ausrichtung des Substrats und/oder Trägersubstrats in der Substratebene E vorgenommen werden kann.

Mit Vorteil sind die E-Aktuatoren entlang oder parallel zur Substratebene E und orthogonal zu der Substrataußenkontur bewegbar ausgebildet. Mit orthogonal zu der Substrataußenkontur ist gemeint, dass die Bewegungsrichtung jedes E-Aktuators orthogonal zu der im nächstliegenden Punkt der Substrataußenkontur beziehungsweise Trägersubstrataußenkontur verlaufenden Tangente ist. Im Falle eines rechteckigen Substrats gilt als Tangente die Seite des Substrats und die Bewegungsrichtung des E-Aktuators schneidet die Seite des Substrats beziehungsweise Trägersubstrats möglichst mittig. Es können allerdings pro Seite mehrere E-Aktuatoren vorgesehen sein.

Soweit die Trägersubstrataußenkontur mit der Substrataußenkontur korrespondiert oder diese am gesamten Umfang der Trägersubstrataußenkontur überragt, bietet das Trägersubstrat bei der Weiterverarbeitung und/oder Bewegung des Verbundes aus Trägersubstrat und Substrat einen hervorragenden Schutz für das Substrat.

Indem die Fixiermittel mindestens einen Fixieraktuator umfassen, der quer, insbesondere orthogonal, zur Substratebene E angeordneten Z-Richtung wirkend ausgebildet ist, kann die Fixierung ebenfalls mit den oben zu Aktuatoren genannten Vorteilen einer Kraft- und/oder Wegsteuerung in definierter Art und Weise erfolgen.

Gemäß einer weiteren Ausführungsform der Erfindung ist mit Vorteil vorgesehen, dass Abstandsmittel zur Einhaltung eines Abstands zwischen Substrat und Trägersubstrat beim Ausrichten der Wafer vorgesehen sind. Hierdurch wird das Substrat beim Ausrichten der Wafer geschont. Als Abstandsmittel sind mit Vorteil seitlich zwischen Substrat und Trägersubstrat einschiebbare Keile, insbesondere Kegelkeile, vorgesehen. Die Keile können durch Aktuatoren in die entsprechende Abstandsposition eingefahren werden.

Weiterhin ist mit Vorteil vorgesehen, dass die Ausrichtungsmittel Z-Aktuatoren zur Bewegung der E-Aktuatoren quer zur Substratebene E, insbesondere in Z-Richtung, umfassen. Auf diese Weise sind die E-Aktuatoren genau gegenüber dem Substrat ausrichtbar. Weiterhin besteht der Vorteil, dass mit den E-Aktuatoren sowohl das Substrat als auch das Trägersubstrat nacheinander ausgerichtet werden können.

Gemäß einer vorteilhaften Ausführungsform umfassen die Fixiermittel Energieeintragsmittel zur, insbesondere lokalen, vorzugsweise punktuellen, Beaufschlagung des Substrats und/oder Trägersubstrats mit Energie zur Fixierung von Substrat und Trägersubstrat. Hierdurch kann auf eine klemmende Fixierung von Substrat und Trägersubstrat beziehungsweise zusätzliche Bauteile zur Fixierung des Substrats mit dem Trägersubstrat verzichtet werden. Gleichzeitig wird aber eine für die Weiterverarbeitung ausreichende Fixierung erreicht.

Besonders vorteilhaft ist es dabei, wenn die Energieeintragsmittel durch den Fixieraktuator gebildet werden oder eine Lichtquelle oder ein Heizmittel als Energieeintragsmittel vorgesehen sind.

Das erfindungsgemäße Verfahren wird verbessert, indem während der Ausrichtung Abstandsmittel zur Einhaltung eines Abstands zwischen Substrat und Trägersubstrat beim Ausrichten der Wafer vorgesehen sind.

Weitere Vorteile, Merkmale und Einzelheiten der Erfindung ergeben sich aus der nachfolgenden Beschreibung bevorzugter Ausführungsbeispiele sowie anhand der Zeichnungen; diese zeigen in:
- Fig. 1:: eine schematische Aufsicht auf die erfindungsgemäße Vorrichtung und
- Fig. 2:: eine schematische Seitenansicht der erfindungsgemäßen Vorrichtung.

In den Figuren sind gleiche Bauteile und Bauteile mit der gleichen Funktion mit den gleichen Bezugszeichen gekennzeichnet.

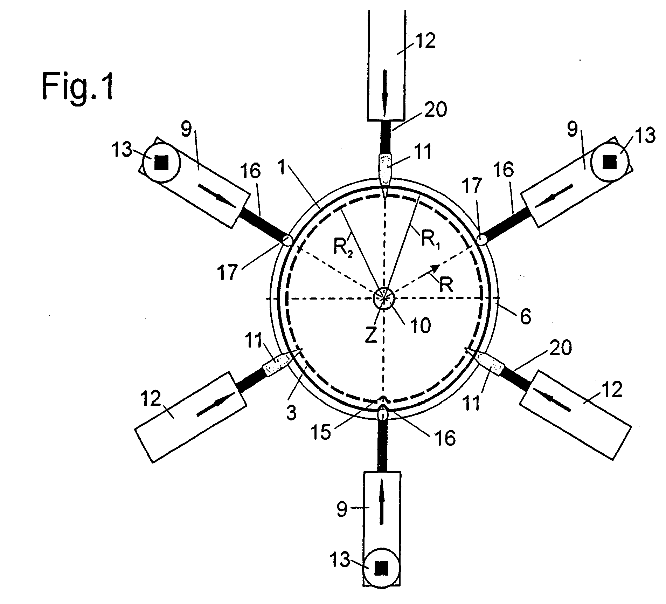

In Figur 1 ist auf einer Aufnahmeeinrichtung 6 (hier: Chuck) ein Substrat 3 (strichliniert) positioniert und oberhalb des Substrats 3 ist ein Trägersubstrat 1 positioniert, das einen größeren Radius R1 als der Radius R2 des Substrats 3 aufweist.

Sowohl das Substrat 3 als auch das Trägersubstrat 1 weisen am Umfang je eine Nase 14, 15 (Notch) auf, die zur rotationsrichtigen Ausrichtung des Substrats 3 und des Trägersubstrats 1 dient. Die Positionierung des Substrats 3 und des Trägersubstrats 1 erfolgt in dem hier gezeigten Ausführungsbeispiel sequenziell. In der gezeigten schematischen Darstellung findet die Positionierung beziehungsweise Ausrichtung des Trägersubstrats 1 statt, während die Positionierung beziehungsweise Ausrichtung des Substrats 3 bereits erfolgt ist.

Die Ausrichtung des Trägersubstrats 1 wird durch drei am Umfang verteilte E-Aktuatoren 9 bewerkstelligt. Einer der E-Aktuatoren 9, im Ausführungsbeispiel der in Figur 1 unten dargestellte E-Aktuator 9, dient gleichzeitig zur genauen Ausrichtung der Nasen 14 und 15.

Die E-Aktuatoren 9 bestehen aus einem Aktuatorarm 16, der mit seinem Aktuatorarmende 17 eine Trägersubstrataußenkontur 18 kontaktierend ausgebildet ist.

In dem gezeigten Ausführungsbeispiel sind drei E-Aktuatoren 9 gleichmäßig am Umfang des runden Trägersubstrats 1 verteilt angeordnet. Die Bewegung der Aktuatorarme 16 ist positionsgeregelt, wobei mit Vorteil die an jedem Aktuatorarm 16 anliegende Kraft einstellbar und/oder messbar ist. Weiterhin kann mit Vorteil ein Wegmesssystem in jedem E-Aktuator 9 vorgesehen sein. Die Bewegung jedes Aktuatorarms 16 erfolgt quer zur Trägersubstrataußenkontur 18, im Fall des in Figur 1 gezeigten runden Trägersubstrats 1 in einer Radialrichtung R.

Jeder der E-Aktuatoren 9 bewegt das Trägersubstrat 1 in Richtung eines Zentrums Z, und zwar in einer Substratebene E oder parallel hierzu.

Weiterhin sind am Umfang des Trägersubstrats 1 verteilt Keilaktuatoren 12 angeordnet, und zwar versetzt zu den E-Aktuatoren 9. Im gezeigten Ausführungsbeispiel sind jeweils drei Keilaktuatoren 12 und drei E-Aktuatoren 9 angeordnet.

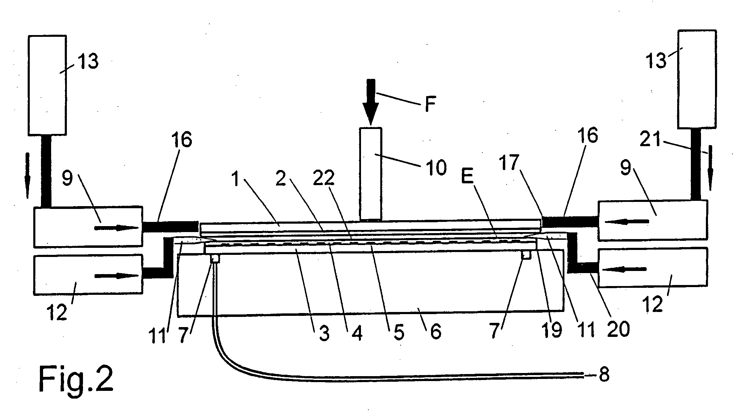

An Keilaktuatorarmen 20 der Keilaktuatoren 12 sind Keile 11 angebracht, die als Abstandhalter während der in Figur 1 gezeigten Ausrichtung des Trägersubstrats 1 gegenüber dem Substrat 3 dienen. Die Funktion der Keile 11 als Abstandhalter ist in Figur 2 gut erkennbar.

In Figur 2 ist darüber hinaus erkennbar, wie das Substrat 3 auf der Aufnahmeeinrichtung 6 fixierbar angeordnet ist, nämlich durch eine nicht dargestellte Vakuumeinrichtung, wobei das Vakuum beziehungsweise der Unterdruck über eine Leitung 8 und eine in eine Aufnahmefläche zur Aufnahme des Substrats 3 auf der Aufnahmeeinrichtung 6 eingebrachte Vertiefung 7 beaufschlagbar ist.

Während des Ausrichtungsvorgangs des Substrats 3 kann die Vakuumeinrichtung mit der Leitung 8 und der Vertiefung 7 gleichzeitig als Luftlager dienen, indem über die Leitung 8 und die Vertiefung 7 ein Überdruck beziehungsweise ein Luftstrom als Luftkissen auf der Aufnahmefläche angelegt wird. Auf diese Weise ist eine quasi reibungsfreie Ausrichtung des Substrats 3 auf der Aufnahmeeinrichtung 6 möglich. In einer alternativen Ausführung kann die Aufnahmeeinrichtung 6 anstelle oder zusätzlich zur Vakuumeinrichtung mit der Leitung 8 und der Vertiefung 7 eine elektrostatische, magnetische und/oder durch Schwerkraft wirkende Fixierung integrieren.

Die Ausrichtung des Substrats 3 erfolgt analog der Ausrichtung des Trägersubstrats 1, die oben beschrieben wurde. Zur Ausrichtung des Substrats 3 werden die E-Aktuatoren 9 durch an den E-Aktuatoren 9 angebrachte Z-Aktuatoren 13 in einer durch Pfeile 21 dargestellten Z-Richtung bewegt, damit der Aktuatorarm 16 beziehungsweise das Aktuatorarmende 17 an einer Substrataußenkontur 19 zur Anlage kommen kann, um die Ausrichtung des Substrats 3 zu bewirken.

Die in Figur 2 dargestellte Position der E-Aktuatoren 9 oberhalb der Keilaktuatoren 12 ist rein schematisch, da die E-Aktuatoren 9 in Wirklichkeit gemäß Figur 1 versetzt zu den Keilaktuatoren 12 angeordnet sind. Die gezeigte Darstellung dient dem leichteren Verständnis der Funktion der erfindungsgemäßen Vorrichtung.

Zur Fixierung des ausgerichteten Substrats 3 mit dem ausgerichteten Trägersubstrat 1 im Zentrum Z ist ein in der Fixierrichtung F wirkender Fixieraktuator 10 oberhalb des Trägersubstrats 1 angeordnet. Der Fixieraktuator 10 ist kraftgeregelt und dient zum lokalen Energieeintrag. Die Art des Energieeintrags richtet sich nach dem Material eines Verbindungsmittels 2 am Trägersubstrat 1 beziehungsweise Verbindungsmittels 4 am Substrat 3. Die Verbindungsmittel 2, 4 können als thermisch aktivierte oder UV-aktivierte oder infrarotaktivierte Kleber beziehungsweise als selbstklebende Schicht ausgebildet sein.

Das Substrat 3 kann außerdem eine Topographie 5 aufweisen.

Der Ablauf der Ausrichtung und Vorfixierung ist wie folgt:
Zunächst wird das Substrat 3 manuell oder über einen nicht dargestellten Roboterarm auf die Aufnahmeeinrichtung 6 geladen. Falls das Trägersubstrat 1 unten liegen soll, wird zunächst das Trägersubstrat 1 geladen. Nachfolgend wird aber von dem in den Figuren dargestellten Ausführungsbeispiel ausgegangen.

Die E-Aktuatoren 9 werden durch die Z-Aktuatoren 13 auf das Niveau des Substrats 3 gefahren.

Anschließend oder gleichzeitig kann über die Leitung 8 Überdruck auf das durch die Vertiefungen 7 gebildete Luftlager geschaltet werden, so dass das Substrat 3 im Wesentlichen reibungsfrei ausgerichtet und zentriert werden kann.

Die E-Aktuatoren 9 werden im Wesentlichen symmetrisch in Richtung des Zentrums Z bewegt, bis alle E-Aktuatoren auf Grund deren Kraftregelung automatisch gestoppt werden. Das Substrat 3 ist zu diesem Zeitpunkt in einer gegenüber der Aufnahmeeinrichtung 6 definierten Position, vorzugsweise zentriert.

In dieser Position wird das Substrat 3 durch Anlegen eines Vakuums an den Vertiefungen 7 über die Leitung 8 fixiert.

Die Positionen jedes der E-Aktuatoren 9 werden gespeichert, so dass in dem in den Figuren gezeigten Ausführungsbeispiel drei Wegpositionen und damit die genaue Position des Substrats 3 gespeichert werden.

Soweit eine Ausrichtung des Trägersubstrats 1 gegenüber dem Substrat 3 mit Abstand erfolgen soll, werden die Keile 11 als Abstandhalter mittels den am Umfang verteilten Keilaktuatoren 12 eingefahren, so dass drei Keile 11, die vorzugsweise kegelförmig ausgebildet sind, am Umfang des Trägersubstrats 1 zwischen Trägersubstrat 1 und Substrat 3 angeordnet sind und einen Abstand zwischen Trägersubstrat 1 und Substrat 3 gewährleisten.

Anschließend wird das Trägersubstrat 1 auf das Substrat 3 beziehungsweise auf die Keile 11 geladen. Gleichzeitig oder im Anschluss daran werden die E-Aktuatoren 9 mittels der Z-Aktuatoren 13 auf das Niveau des Trägersubstrats 1 gebracht. Analog der Ausrichtung des Substrats 3 erfolgt nun die Ausrichtung des Trägersubstrats 1 symmetrisch und äquidistant zu den für das Substrat 3 gespeicherten Positionen. Sobald das Trägersubstrat 1 gegenüber dem Substrat 3 ausgerichtet ist, wird durch den Fixieraktuator 10 punktuelle Energie (hier im Zentrum Z) auf das Trägersubstrat 1 eingebracht und das Trägersubstrat 1 mit dem Substrat 3 kontaktiert und vorfixiert.

Die Vorfixierung kann entweder in Anwesenheit oder bei herausgefahrenen Keilen 11 erfolgen, wobei sich das Trägersubstrat 1 im Falle von eingefahrenen Keilen 11 bei der Vorfixierung im Zentrum verbiegen wird.

Nachdem die Haftwirkung des Verbindungsmittels 2 und/oder des Verbindungsmittels 4 punktuell eingetreten ist, wird der Fixieraktuator 10 nach oben weggefahren. Anschließend werden die Keile 11 über die Keilaktuatoren 12 herausgefahren und die E-Aktuatoren zurückgefahren. Das Substrat 3 und das Trägersubstrat 1 sind nun entlang einer Kontaktfläche 22 des Substrats 3 in Kontakt.

Nach dem Lösen des Vakuums 7 kann der Verbund aus Trägersubstrat 1 und Substrat 3 zur weiteren Verarbeitung in weiteren Prozessschritten/Anlagen entladen werden, beispielsweise über einen Roboterarm.

### Bezugszeichenliste

- 1: Trägersubstrat
- 2: Verbindungsmittel
- 3: Substrat
- 4: Verbindungsmittel
- 5: Topographie
- 6: Aufnahmeeinrichtung
- 7: Vertiefung
- 8: Leitung
- 9: E-Aktuator
- 10: Fixieraktuator
- 11: Keil
- 12: Keilaktuator
- 13: Z-Aktuator
- 14: Nase
- 15: Nase
- 16: Aktuatorarm
- 17: Aktuatorarmende
- 18: Trägersubstrataußenkontur
- 19: Substrataußenkontur
- 20: Keilaktuatorarm
- 21: Pfeil
- 22: Kontaktfläche
- E: Substratebene
- F: Fixierrichtung
- R1: Radius
- R2: Radius
- Z: Zentrum

## Patentansprüche

1. Vorrichtung zur Ausrichtung und Vorfixierung eines flächigen Substrats (3) auf einem Trägersubstrat (1) für die Weiterverarbeitung des Substrats (3) mit folgenden Merkmalen:
- Ausrichtungsmitteln (9, 16, 17) zur Ausrichtung einer Substrataußenkontur (19) des Substrats (3) relativ zu einer Trägersubstrataußenkontur (18) des Trägersubstrats (1) durch Einwirkung auf die Substrataußenkontur (19) und/oder der Trägersubstrataußenkontur (18) in Richtung eines Zentrums Z, wobei die Ausrichtung entlang oder parallel zu einer durch eine Kontaktfläche (22) des Substrats (3) mit dem Trägersubstrat (1) aufgespannten Substratebene (E) erfolgt und
- Fixiermitteln (10, 2, 4) zur zumindest teilweisen Vorfixierung des ausgerichteten Substrats (3) auf dem Trägersubstrat (1).
**dadurch gekennzeichnet,**
**dass** die Ausrichtungsmittel (9, 16, 17) mindestens drei an der Substrataußenkontur (19) verteilt anordenbare E-Aktuatoren (9) zur Ausrichtung des Substrats (3) sowie Positionserfassungsmittel zur Erfassung der Position der E-Aktuatoren (9) umfassen und das Substrat (3)/Trägersubstrat (1) positionsgeregelt zu für das Trägersubstrat (1)/Substrat (3) gespeicherten Positionen ausrichtbar ist.

2. Vorrichtung nach Anspruch 1,
**dadurch gekennzeichnet,**
**dass** die Ausrichtungsmittel (9, 16, 17), insbesondere ausschließlich, in Radialrichtung R des Substrats (3) und/oder des Trägersubstrats (1) wirkend ausgebildet sind.

3. Vorrichtung nach Anspruch 1,
**dadurch gekennzeichnet,**
**dass** die Ausrichtungsmittel (9, 16, 17), insbesondere ausschließlich, quer zur Substrataußenkontur (19) und/oder zur Trägersubstrataußenkontur (18) wirkend ausgebildet sind.

4. Vorrichtung nach Anspruch 1,
**dadurch gekennzeichnet,**
**dass** die E-Aktuatoren (9) entlang oder parallel zur Substratebene (E) und orthogonal zu der Substrataußenkontur (19) bewegbar ausgebildet sind.

5. Vorrichtung nach einem der vorhergehenden Ansprüche,
**dadurch gekennzeichnet,**
**dass** das Substrat (3)/Trägersubstrat (1) symmetrisch und äquidistant zu für das Trägersubstrat (1)/Substrat (3) gespeicherten Positionen ausrichtbar ist.

6. Vorrichtung nach einem der vorhergehenden Ansprüche,
**dadurch gekennzeichnet,**
**dass** die Fixiermittel (10, 2, 4) mindestens einen Fixieraktuator umfassen, der in einer quer, insbesondere orthogonal, zur Substratebene E angeordneten Z-Richtung wirkend ausgebildet ist.

7. Vorrichtung nach einem der vorhergehenden Ansprüche,
**dadurch gekennzeichnet,**
**dass** Abstandsmittel (11, 12, 20) zur Einhaltung eines Abstands zwischen dem Substrat (3) und dem Trägersubstrat (1) beim Ausrichten des Trägersubstrats (1) zum Substrat (3) vorgesehen sind.

8. Vorrichtung nach Anspruch 1 oder 5,
**dadurch gekennzeichnet,**
**dass** die Ausrichtungsmittel (9, 16, 17, 13) Z-Aktuatoren (13) zur Bewegung der E-Aktuatoren (9) quer zur Substratebene E, insbesondere in Z-Richtung, umfassen.

9. Vorrichtung nach einem der vorhergehenden Ansprüche,
**dadurch gekennzeichnet,**
**dass** die Fixiermittel (10) Energieeintragsmittel zur, insbesondere lokalen, vorzugsweise punktuellen, Beaufschlagung des Substrats (3) und/oder Trägersubstrats (1) mit Energie zur Vorfixierung von Substrat (3) und Trägersubstrat (1) umfassen.

10. Vorrichtung nach Anspruch 9,
**dadurch gekennzeichnet,**
**dass** die Energieeintragsmittel durch den Fixieraktuator (10) und/oder durch eine Lichtquelle und/oder durch ein Heizmittel gebildet sind.

11. Verfahren zur Ausrichtung und Vorfixierung eines flächigen Substrats (3) auf einem Trägersubstrat (1) für die Weiterverarbeitung des Substrats mit folgenden Merkmalen:
- Ausrichtung einer Substrataußenkontur (19) des Substrats (3) relativ zu einer Trägersubstrataußenkontur (18) des Trägersubstrats (1) durch Einwirkung auf die Substrataußenkontur (19) und/oder der Trägersubstrataußenkontur (18) in Richtung eines Zentrums Z durch Ausrichtungsmittel (9, 16, 17), wobei die Ausrichtung entlang oder parallel zu einer durch eine Kontaktfläche (22) des Substrats (3) aufgespannten Substratebene (E) erfolgt und
- zumindest teilweise Vorfixierung des ausgerichteten Substrats (3) auf dem Trägersubstrat (1) durch Fixiermittel (10).
**dadurch gekennzeichnet, dass** die Ausrichtungsmittel (9, 16, 17) mindestens drei an der Substrataußenkontur (19) verteilt anordenbare E-Aktuatoren (9) zur Ausrichtung des Substrats (3) sowie Positionserfassungsmittel zur Erfassung der Position der E-Aktuatoren (9) umfassen und das Substrat (3)/Trägersubstrat (1) positionsgeregelt zu für das Trägersubstrat (1)/Substrat (3) gespeicherten Positionen ausgerichtet wird.

12. Verfahren nach Anspruch 11,
**dadurch gekennzeichnet,**
**dass** während der Ausrichtung Abstandsmittel (11, 12, 20) zur Einhaltung eines Abstands zwischen Substrat (3) und Trägersubstrat (1) beim Ausrichten des Substrats (3) mit dem Trägersubstrat (1) vorgesehen sind.

## Claims

1. Device for aligning and prefixing a flat substrate (3) on a carrier substrate (1) for the further processing of the substrate (3) with the following features:
- Aligning means (9, 16, 17) for aligning a substrate's outside contour (19) of the substrate (3) relative to a carrier substrate's outside contour (18) of the carrier substrate (1) by action on the substrate's outside contour (19) and/or on the carrier substrate's outside contour (18) in direction to a center Z, whereby the alignment along or parallel to a substrate plane E that is formed with the carrier substrate (1) is carried out by a contact surface (22) of the substrate (3), and
- attaching means (10, 2, 4) for at least partial prefixing of the aligned substrate (3) on the carrier substrate (1),
**characterized in that**
the aligning means (9, 16, 17) comprise at least three E-actuators (9) that can be arranged distributed onto the substrate's outside contour (19) for aligning the substrate (3) as well as position-detecting means for detecting the position of the E-actuators (9) and that the substrate (3) / carrier substrate (1) can be aligned position controlled with regard to the stored positions for the carrier substrate (1) / substrate (3).

2. Device according to claim 1, wherein the aligning means (9, 16, 17) are designed to act especially exclusively in the radial direction R of the substrate (3) and/or the carrier substrate (1).

3. Device according to claim 1, wherein the aligning means (9, 16, 17) are designed to act especially exclusively crosswise to the substrate's outside contour (19) and/or to the carrier substrate's outside contour (18).

4. Device according to claim 1, wherein the E-actuators (9) are designed to move along or parallel to the substrate plane E and orthogonally to the substrate's outside contour (19).

5. Device according to one of the preceding claims, wherein the substrate (3) / carrier substrate (1) can be aligned symmetrically and equidistantly to the position stored for the substrate (3) / carrier substrate (1).

6. Device according to one of the preceding claims, wherein the attaching means (10, 2, 4) comprise at least one attaching actuator that is designed to act in a Z-direction, arranged crosswise, in particular orthogonally, to the substrate plane E.

7. Device according to one of the preceding claims, wherein spacing means (11, 12, 20) are provided for maintaining a distance between the substrate (3) and the carrier substrate (1) when the carrier substrate (1) is oriented toward the substrate (3).

8. Device according to one of the claim 1 or 5, wherein the aligning means (9, 16, 17, 13) comprise Z-actuators (13) for moving the E-actuators (9) crosswise to the substrate plane E, in particular in the Z-direction.

9. Device according to one of the preceding claims, wherein the attaching means (10) comprise energy-inserting means for, in particular, local application, preferably at points, of the substrate (3) and/or carrier substrate (1) with energy for the prefixing of the substrate (3) and carrier substrate (1).

10. Device according to claim 9, wherein the energy-inserting means are formed by the attaching actuator (10) and/or by a light source and/or by a heating means.

11. Process for aligning and prefixing a flat substrate (3) on a carrier substrate (1) for the further processing of the substrate with the following features:
- position controlled aligning a substrate's outside contour (19) of the substrate (3) relative to a carrier substrate's outside contour (18) of the carrier substrate (1) by action on the substrate's outside contour (19) and/or on the carrier substrate's outside contour (18) in direction to a center Z by aligning means (9, 16, 17), whereby the alignment along or parallel to a substrate plane E that is formed by a contact surface (22) of the substrate (3) is carried out, and
- at least partial prefixing of the aligned substrate (3) on the carrier substrate (1) by attaching means (10),
**characterized in that**
the aligning means (9, 16, 17) comprise at least three E-actuators (9) that can be arranged distributed onto the substrate's outside contour (19) for aligning the substrate (3) as well as position-detecting means for detecting the position of the E-actuators (9) and that the substrate (3) / carrier substrate (1) can be aligned position controlled with regard to the stored positions for the carrier substrate (1) / substrate (3).

12. Process according to claim 11, wherein during the alignment, spacing means (11, 12, 20) are provided to maintain a distance between substrate (3) and carrier substrate (1) when aligning the substrate (3) with the carrier substrate (1).

## Revendications

1. Dispositif pour aligner et préfixer un substrat plan (3) sur un substrat porteur (1) pour le traitement ultérieur du substrat (3), comprenant les caractéristiques suivantes :
- des moyens d'alignement (9, 16, 17) pour aligner un contour extérieur de substrat (19) du substrat (3) par rapport à un contour extérieur de substrat porteur (18) du substrat porteur (1) par action sur le contour extérieur de substrat (19) et/ou le contour extérieur de substrat porteur (18) en direction d'un centre Z, sachant que l'alignement a lieu le long ou parallèlement à un plan de substrat (E) tendu par une surface de contact (22) du substrat (3) avec le substrat porteur (1) et
- des moyens de fixation (10, 2, 4) pour préfixer au moins partiellement le substrat (3) aligné sur le substrat porteur (1),
**caractérisé en ce que**
les moyens d'alignement (9, 16, 17) présentent au moins trois déclencheurs E (9) pouvant être disposés en étant répartis sur le contour extérieur de substrat (19) pour aligner le substrat (3), ainsi que des moyens de détection de position pour détecter la position des déclencheurs E (9), et le substrat (3)/substrat porteur (1) peut être aligné réglé en position par rapport à des positions stockées en mémoire pour le substrat porteur (1)/substrate (3).

2. Dispositif selon la revendication 1,
**caractérisé en ce que**
les moyens d'alignement (9, 16, 17) sont conçus en agissant, en particulier exclusivement, dans le sens radial R du substrat (3) et/ou du substrat porteur (1).

3. Dispositif selon la revendication 1,
**caractérisé en ce que**
les moyens d'alignement (9, 16, 17) sont conçus en agissant, en particulier exclusivement, transversalement au contour extérieur de substrat (19) et/ou au contour extérieur de substrat porteur (18).

4. Dispositif selon la revendication 1,
**caractérisé en ce que**
les déclencheurs E (9) sont conçus mobiles le long ou parallèlement au plan de substrat (E) et perpendiculairement au contour extérieur de substrat (19).

5. Dispositif selon l'une des revendications précédentes,
**caractérisé en ce que**
le substrat (3)/substrat porteur (1) peut être aligné de façon symétrique et équidistante aux positions stockées en mémoire pour le substrat porteur (1)/substrat (3).

6. Dispositif selon l'une des revendications précédentes,
**caractérisé en ce que**
les moyens de fixation (10, 2, 4) comprennent au moins un déclencheur de fixation qui est formé en agissant dans un sens Z disposé transversalement, en particulier perpendiculairement, au plan de substrat E.

7. Dispositif selon l'une des revendications précédentes,
**caractérisé en ce que**
des écarteurs (11, 12, 20) sont prévus pour maintenir un écart entre le substrat (3) et le substrat porteur (1) lors de l'alignement du substrat porteur (1) par rapport au substrat (3).

8. Dispositif selon la revendication 1 ou 5,
**caractérisé en ce que**
les moyens d'alignement (9, 16, 17, 13) comprennent des déclencheurs Z (13) pour déplacer les déclencheurs E (9) transversalement au plan de substrat E, en particulier dans le sens Z.

9. Dispositif selon l'une des revendications précédentes,
**caractérisé en ce que**
les moyens de fixation (10) comprennent des moyens d'apport d'énergie pour alimenter, en particulier localement, de préférence ponctuellement, le substrat (3) et/ou le substrat porteur (1) en énergie pour préfixer le substrat (3) et le substrat porteur (1).

10. Dispositif selon la revendication 9,
**caractérisé en ce que**
les moyens d'apport d'énergie sont formés par le déclencheur de fixation (10) et/ou une source lumineuse et/ou un moyen de chauffage.

11. Procédé pour aligner et préfixer un substrat plan (3) sur un substrat porteur (1) pour le traitement ultérieur du substrat, comprenant les caractéristiques suivantes :
- alignement d'un contour extérieur de substrat (19) du substrat (3) par rapport à un contour extérieur de substrat porteur (18) du substrat porteur (1) par action sur le contour extérieur de substrat (19) et/ou le contour extérieur de substrat porteur (18) en direction d'un centre Z par des moyens d'alignement (9, 16, 17), sachant que l'alignement a lieu le long ou parallèlement à un plan de substrat (E) tendu par une surface de contact (22) du substrat (3) et
- préfixation au moins partiellement du substrat (3) aligné sur le substrat porteur (1) par des moyens de fixation (10),
**caractérisé en ce que** les moyens d'alignement (9, 16, 17) présentent au moins trois déclencheurs E (9) pouvant être disposés en étant répartis sur le contour extérieur de substrat (19) pour aligner le substrat (3) ainsi que des moyens de détection de position pour détecter la position des déclencheurs E (9) et le substrat (3)/substrat porteur (1) est réglé en position par rapport à des positions stockées en mémoire pour le substrat (3)/substrat porteur (1).

12. Procédé selon la revendication 11,
**caractérisé en ce que**
pendant l'alignement, des écarteurs (11, 12, 20) sont prévus pour maintenir un écart entre le substrat (3) et le substrat porteur (1) lors de l'alignement du substrat (3) avec le substrat porteur (1).
